# EUROPÄISCHE PATENTSCHRIFT

(11) **EP 1 946 367 B1**
(45) Veröffentlichungstag und Bekanntmachung des Hinweises auf die Patenterteilung: **26.10.2016**
(21) Anmeldenummer: 06807782.5
(22) Anmeldetag: 08.11.2006
(51) Int. Cl.: H01L 21/768

(54) **VERFAHREN ZUM HERSTELLEN ELEKTRISCH LEITENDER DURCHFÜHRUNGEN DURCH NICHT- ODER HALBLEITENDE SUBSTRATE**
METHOD FOR PRODUCING ELECTRICALLY CONDUCTIVE VIAS THROUGH NON-CONDUCTIVE OR SEMICONDUCTIVE SUBSTRATES
PROCÉDÉ DE FABRICATION DE TROUS TRAVERSANTS CONDUCTEURS D ÉLECTRICITÉ À TRAVERS DES SUBSTRATS DIÉLECTRIQUES OU SEMI-CONDUCTEURS

(30) Priorität: 09.11.2005 DE 102005053494
(43) Veröffentlichungstag der Anmeldung: 23.07.2008
(73) Patentinhaber: Fraunhofer-Gesellschaft zur Förderung der angewandten Forschung e.V., 80686 München (DE)
(72) Erfinder: REINERT, Wolfgang, 24536 Neumünster (DE)
(74) Vertreter: Strehl Schübel-Hopf & Partner
(86) Internationale Anmeldenummer: PCT/EP2006/068247
(87) Internationale Veröffentlichungsnummer: WO 2007/054521

(56) Entgegenhaltungen:
- EP-A- 1 564 805
- EP-A2- 1 376 678
- DE-A1- 10 244 077
- US-A1- 2001 028 113
- US-A1- 2005 167 812

## Beschreibung

Die vorliegende Erfindung betrifft die Erzeugung elektrischer Durchführungen durch nicht- oder halbleitende Substrate, insbesondere für IC kompatible Substrate, und damit die Erzeugung von Substraten bzw. elektrischen/elektronischen Bauelementen, die solche Durchführungen enthalten. Ferner betrifft die Erfindung die entsprechenden Substrate bzw. Bauelemente selbst.

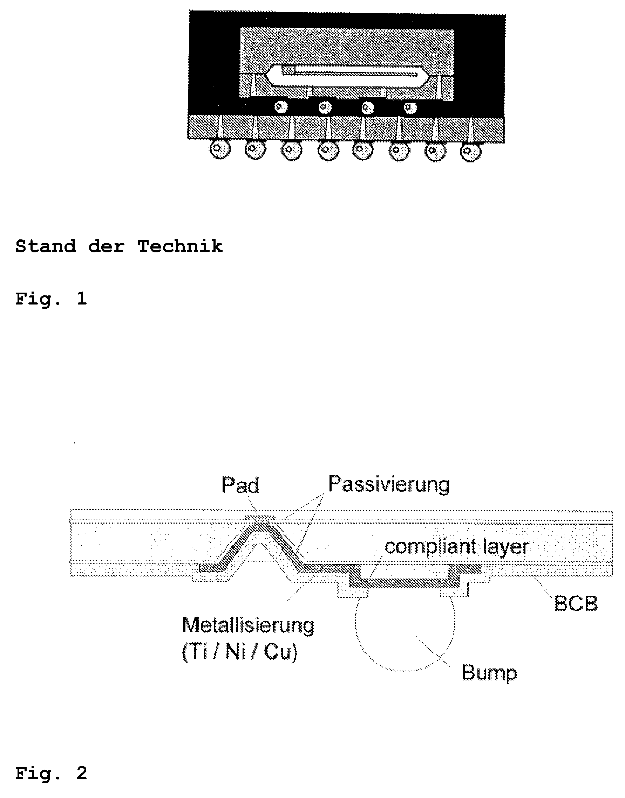

Nach wie vor werden die meisten integrierten Schaltungen und MEMS-Bauteile mittels Drahtbondtechnik kontaktiert. Zum Teil werden diese Bauteile aus Platzgründen kompakter mittels Flip Chip Technik aufgebaut und kontaktiert. Hierzu werden erhabene Kontaktstrukturen (sog. Bumps) auf oder in der Nähe der Bondkontaktflächen aufgebracht. Die Bumps bestehen zumeist aus Weichlot oder Gold, abgeschieden auf einer Grundmetallisierung (UBM). Für noch höher integriert aufgebaute Produkte der nächsten Generationen besteht ein Trend zu Systemen in einem Gehäuse (SIP; siehe **Figur 1****,** wo ein SIP als CSP konfektioniert zur Messung von Drehraten, Beschleunigungen, etc. gezeigt ist, aufgebaut aus einem MEMS-CSP und einem durchkontaktierten ASIC). Um die elektrischen Kontakte von Ebene zu Ebene zu führen, sind direkte Durchkontaktierungen durch die Chips das kompakteste, wenn auch derzeit nicht das billigste Verfahren.

J. Gobet et al. beschreiben in ihrem Artikel "IC compatible fabrication of through-wafer conductive vias", SPIE Vol. 3223 (1997), S. 17-25, die Erzeugung von leitenden Durchgängen, sog. Vias, durch einen Siliziumwafer hindurch. Das durch einen negativen Photoresist geschützte Substrat wird an den unbeschichteten Stellen mit Hilfe eines Plasmaätz-Verfahrens angeätzt, bis ein Durchgang durch das Substrat entsteht. Dieser wird mit Hilfe einer Parylen-Schicht isoliert und sodann mit Hilfe von Sputtertechnik mit Metall ausgekleidet. Gleichzeitig werden mit diesem Verfahren leitende Strukturen auf beiden Seiten des Substrats erzeugt.

Allerdings ist der Metallisierungsschritt nach Aussage der Autoren besonders kritisch, da eine ausreichende Abscheidung des Metalls innen auf den senkrecht verlaufenden Via-Wänden kaum zu erreichen ist. Dieses Problem ist umso schwerwiegender, je ungünstiger das Verhältnis von Durchmesser des Substrats zum Durchmesser des Via ist. Die offenen Durchlochungen machen es außerdem erforderlich, für die Metallisierung eine solche Verfahrensstrategie zu wählen, bei der beide Seiten des Substrats mit Metall beschichtet werden.

Eine alternative Strategie wird in der US-Patentanmeldung 2001/28113 A1 kritisch diskutiert. Dort wird auf älteren Stand der Technik verwiesen, gemäß dem die Ankontaktierung einer leitenden Struktur der Vorderseite unter Erzeugen einer rückseitigen Ausnehmung erfolgt, die durch Nassätzen gebildet wird, Kuppelform besitzt und in einem späteren Schritt durch elektrolytisches oder nicht-elektrolytisches Nickel-Plattieren metallisiert wird. Die Ausnehmung hat eine Basisbreite, die mindestens dem Doppelten der Dicke des Substrats entspricht, um die Abscheidung von Nickel in der sonst zu engen Ausnehmung möglich zu machen. Dies wird allerdings als nachteilig bezeichnet.

In US 2005/0167812 A1 wird ein Verfahren zum Herstellen elektrisch leitender Durchführungen durch ein Halbleitersubstrat offenbart, das sich besonders für die Herstellung stapelfähiger Halbleiter-Bauteile eignen soll. Hierfür wird vorderseitig eine Kontaktstelle ausgebildet, die sodann von der Rückseite des Substrats her mit Hilfe eines konischen Ätzlochs freigelegt wird. DE 10 244077 A1 zeigt ein vergleichbares Verfahren, jedoch ohne konische Ausbildung der Ätzlöcher.

Aufgabe der vorliegenden Erfindung ist es, die genannten Nachteile zu beseitigen und ein mit relativ wenigen Schritten durchführbares und damit kostengünstiges Verfahren zur Realisierung von Durchführungen durch ein nicht- oder halbleitendes Substrat bereitzustellen.

Diese Aufgabe wird durch ein Verfahren gemäß der Patentansprüche 1 bis 25 gelöst.

Mit dem erfindungsgemäßen Verfahren lassen sich sowohl gestapelte Chipaufbauten, wie sie z.B. als MEMS-CSP, Opto-CSP oder dergleichen zur Messung von Drehraten, Beschleunigungen etc. benötigt werden, als auch Einzelbauteile wie CCD-, CMOS oder BICMOS Bildsensoren (Kamerachips) erzeugen. Die MEMS-CSP und Opto-CSP mit vertikalen elektrischen Durchführungen können über SMT-Bestücker sehr einfach, aber hochgenau bestückt werden und ermöglichen die Realisierung kleinster Baugruppen zu geringen Kosten. **Figur 2** zeigt die Durchkontaktierung am Beispiel eines Bildsensors von dem Stand der Technik auf.

Als Substrat-Materialien kommen Halbleiter wie Siliziumwafer in Frage, aber auch andere nichtleitende Substratmaterialien wie GaAs, Glas, Pyrex und Keramik; das Verfahren ist diesbezüglich vom Prinzip her nicht beschränkt.

Die erfindungsgemäß eingesetzte Technologie nutzt nach Möglichkeit eine Verfahrensführung und Verfahrensparameter, die vorprozessierte Bauteile (z.B. auf Waferebene) nicht in ihren Funktionseigenschaften verändern. Insbesondere lassen sich alle Schritte bei Temperaturen von unter 400°C, besonders bevorzugt sogar von unter 200°C durchführen, was einen Einsatz des Verfahrens auch für die Herstellung von Farbkamera-Bildsensoren geeignet macht. Ist das erfindungsgemäße Verfahren auf die Erzeugung integrierter Schaltungssysteme gerichtet, lassen sich hierfür leicht IC-kompatible Hilfsstoffe und Materialien einsetzen. Sonderprozesse bei der Lithographie werden dadurch vermieden, dass zu keiner Zeit offene Durchlochungen im Halbleitersubstrat vorhanden sind.

Das Verfahren ist sowohl anwendbar auf unbeschichtete Substrate als auch auf Substrate, deren Oberflächen ein- oder beidseitig mit einer Beschichtung, beispielsweise einer Passivierung, abgedeckt sind. Ein Beispiel hierfür ist ein Silizium-Wafer, der mit einer dünnen SiO₂-Schicht bedeckt ist.

Schritt (d) des Verfahrens, das Ausbilden mindestens einer Ausnehmung im Substrat von dessen Rückseite aus, erfolgt vorzugsweise mit Hilfe eines Ätzverfahrens. Hierbei werden über eine lithographisch erzeugte Maske auf der Substratrückseite Vertiefungen in das Substrat geätzt. Die Maske kann auf das Substrat aufgelegt sein, so dass sie später wieder abgenommen oder auf sonstige Weise entfernt werden kann; sie kann aber auch aus einem Material bestehen, das am Substrat haftet, z.B. eine gegen das Ätzmedium resistente Lack- oder Aluminiumschicht oder eine SiO₂-Schicht ("Hartmaske") sein. Diese kann, muss aber nicht, auch nachfolgend auf dem Substrat verbleiben. Das Ätzen kann ein Plasmaätzverfahren unter Einsatz einer geeigneten Gasmischung sein. Diese kann z.B. ein oxidierendes Schwefelhexafluorid enthalten, wenn das Substrat ein Siliziumwafer ist. Silizium lässt sich insbesondere mit Hilfe des sog. Hochratenätzens (Deep Reactive Ion Etching, DRIE) behandeln. Derartige Ätzverfahren greifen Silizium an, nicht aber SiO₂, Aluminium oder Lacke. Alternativ kann die Ausnehmung mechanisch, z.B. durch abtragende UV-Laserbestrahlung, erzeugt werden.

Die gemäß Schritt (d) erhaltenen Vertiefungen können beliebige Durchmesser besitzen. Häufig wird man Durchmesser von etwa 10 bis 250 µm, vorzugsweise 20 bis 100 µm anstreben, bei einer Dicke des Substrats von vorzugsweise 35 bis 500 µm.

In der Erfindung erhalten die Ausnehmungen eine konusähnliche Form, bei der sich der Querschnitt der Ausnehmungen in Richtung der Vorderseite des Substrats verkleinert. Die Flanken dieser Ausnehmung sind bei späteren Beschichtungsvorgängen wesentlich besser zugänglich und erlauben eine gleichmäßigere Auflage von Material als eine via-ähnliche Durchführung mit gleich bleibendem Durchmesser. Sie weisen vorzugsweise einen Flankenwinkel von etwa 90°-70°, bevorzugt 85°-75° und ganz besonders bevorzugt von etwa 80° auf. Die Ausnehmungen können, müssen aber nicht, gleichmäßig bzw. symmetrisch sein. Die konusähnliche Form der Ausnehmungen kann sich über die gesamte Dicke des Substrates hinweg erstrecken; statt dessen kann man jedoch auch mit einer sog. "Unterätzung" arbeiten, bei der sich der Lochdurchmesser erst kurz hinter der rückseitigen Außenfläche auf seinen maximalen Durchmesser weitet und dann konusförmig verengt.

Eine Flankenstruktur kann man beispielsweise durch Ätzen nach dem Bosch-Verfahren (abwechselndes Anwenden von Ätzgas, z.B. SF₆, und einem Gas, das für eine Passivierung durch Plasmapolymerisation sorgen kann, z.B. C₄F₈) oder mit Hilfe eines Trockenätzprozesses mit SF₆/O₂ als Mischgas erreichen, wobei sich SiO₂ als anorganische Seitenwandpassivierung ausbildet.

Im herkömmlichen Bosch-Prozess entstehen im Prozessgas Ionen und Radikale. Die Ionen werden über eine Vorspannung gerichtet auf den Wafer gelenkt, tragen durch ihre Sputterwirkung beim Auftreffen die Passivierungsschicht am Lochgrund ab und reagieren dort mit Silizium zu gasförmigem SiF. Auf die Seitenwände treffen entsprechend sehr wenige Ionen auf. Wenn man nun die Vorspannung abschaltet und primär mit den Neutralteilchen im schon freigelegten Bereich ätzt, wobei man gegebenenfalls den Anteil der Neutralteilchen durch Erhöhung des Arbeitsgasdrucks erhöht, kann man die Ausbildung der Seitenwandpassivierung beeinflussen. Dies kann zusätzlich durch die Dauer der Passivierung geschehen. Eine nicht geschlossene Seitenwandpassivierung ist für die Neutralteilchen angreifbar, so dass eine nach außen gerichtete Ätzwirkung entsteht. Durch Steuern des Verhältnisses von gerichteter ionischer Ätzung (durch unterschiedliche Vorspannung) zur Seitenwandpassivierungsdicke bei gleichem Arbeitsgasdruck kann man somit die Ausbildung eines Lochwinkels bestimmen.

Die Bedingungen des Atzverfahrens werden so gewählt, dass die auf der Vorderseite des Substrats befindliche elektrisch leitende Kontaktstelle von der Rückseite her freigelegt, aber nicht angegriffen wird. Wenn die Kontaktstelle freigelegt ist, wird der Ätzprozess durch seine sehr geringe Abtragsrate auf diesem Material angehalten. Die Kontaktstelle deckt dabei die gebildete Vertiefung zur Vorderseite hin so ab, dass das Substrat gasdicht bleibt.

Die Kontaktstellen selbst sind den Erfordernissen des späteren Bauteils entsprechend ausgebildet. Sie werden meist aus einem geeigneten Metall bestehen, das z.B. aufgesputtert oder aufgedampft wurde. Es kann sich dabei, muss aber nicht, um Drahtbondflächen handeln. Eine besonders bevorzugte Variante der Ausbildung von Kontaktstellen wird weiter unten beschrieben.

In spezifischen Fällen kann anschließend die leitende Struktur gemäß Schritt (c) und (e) direkt auf das Substrat aufgebracht werden Dies kann z.B. für Halbleiterchips günstig sein, die für spezielle Fälle wie Hochleistungsverstärker für Mobiltelefone vorgesehen sind. Hierdurch kann eine bessere Potentialanpassung an Erde und gleichzeitig eine bessere Entwärmung des Chips erhielt werden. Natürlich ist diese Verfahrensführung auch in all solchen Fällen geeignet, in denen das Substrat ein Nichtleiter ist.

Die leitende Struktur gemäß Schritt (c) oder (e) kann durch gängige Techniken, z.B. physikalisches Sputtern, Aufdampfen, Elektroplattierung oder stromloses Abscheiden aus Lösungen aufgebracht werden. Sie kann ein- oder mehrlagig sein. Geeignete Materialien hierfür sind z.B. Metalle wie Titan, Chrom, Wolfram, TiN, Aluminium, Nickel, Gold, Silber oder Kupfer oder diese Metalle enthaltende Legierungen. Geeignete Mehrlagen Metallisierungen sind z.B. Ti/Ni/Ag, TiW/Gold, Cr/Cu/Au, AI/NiV/Cu oder Ti/TiN/Cu. Wird eine durchgehende Schicht erzeugt, kann diese anschließend durch übliche Methoden wie vorzugsweise Spin- oder Trockenresist-Lithographie und Nassätzen, aber auch durch Trockenätzen oder Lift-Off-Technologie strukturiert werden. Hierbei können sowohl die Metallisierung um die Durchführungen herum als auch Leiterbahnen und Lötkontaktflächen gleichzeitig strukturiert werden. Die Lötflächen können abgesetzt von den Durchführungen strukturiert angeordnet werden oder aber mit den Durchführungen überlagert sein. In diesem Falle werden Kontaktwerkstoffe direkt auf die Durchführung aufgebracht.

Alternativ kann die leitende Struktur natürlich unter Zuhilfenahme einer Maske direkt in strukturierter Form aufgebracht werden.

In denjenigen Fällen, in denen das Substrat gegen die elektrisch leitende Durchführung isoliert sein sollte oder dies gewünscht ist, wird vor dem Aufbringen der leitenden Struktur gemäß Schritt (e) eine Passivierungsschicht auf dem Substrat angeordnet.

Wenn das Substrat aus Silizium besteht, kann diese beispielsweise aus Siliciumdioxid, Siliciumnitrid oder einem Siliciumoxidnitrid bestehen. Der Vorteil solcher Passivierungen ist deren hohe Temperaturbeständigkeit. Alternativ kann in allen Fällen, unabhängig vom Material des Substrats, ein isolierendes Polymer, insbesondere ein organisches oder anorganisch-organisches Polymer, aufgebracht werden. Günstig sind auch hierfür Materialien, die relativ weitgehend temperaturbeständig sind. In Betracht kommen dafür daher ebenfalls anorganische Materialien, aber auch z.B. organische Polymere wie Parylen, das bis etwa 290°C stabil ist. Die Passivierungsschicht kann in beliebiger Dicke aufgebracht werden; günstig sind z.B. 0,4-2 µm.

Die Passivierungsschicht kann auf beliebige Weise aufgebracht werden. Günstig sind auch hierfür Niedertemperatur Plasma- oder plasmaunterstützte Verfahren, z.B. für den Fall, dass die Schicht aus Parylen oder aus SiN besteht.

Vorzugsweise deckt die Passivierung nicht nur die Ausnehmungen im Substrat ab, sondern auch gewünschte Teile oder sogar die gesamte Rückseite des Substrats. Alternativ kann sie strukturiert aufgebracht werden.

Wenn die Passivierungsschicht derart aufgebracht wird, dass sie auch die Rückseiten der vorderseitig befindlichen Kontaktstellen abdeckt, müssen diese vor Aufbringen der leitenden Schicht gemäß Schritt (e) wieder freigelegt werden. Dies kann mit Hilfe eines Gasphasenätzprozesses erfolgen. Wenn das Metall der Kontaktstelle während der Passivierung oxidiert wurde oder aus anderen Gründen oxidiert war, kann es z.B. durch Argon-Ionenbeschuss wieder entoxidiert werden. Die nachfolgend abgeschiedene Metallschicht hat so einen kleinen Übergangswiderstand und eine hohe Strombelastbarkeit.

Nach der Herstellung der Durchführungen gemäß Schritt (e) kann die Rückseite des Substrats bei Bedarf teilweise oder komplett bis auf die für spätere Kontaktierungen vorgesehenen Orte (Lötflächen) und/oder Sägestraßen mit einer Passivierungsschicht abgedeckt werden. Diese Schicht besteht vorzugsweise aus Benzocyclobuten (BCB) oder Polyimid (PI). Daneben kommen andere organische Polymere, aber auch anorganisch-organische oder rein anorganische Materialien wie SiO₂ hierfür in Frage. Die Passivierungsschicht kann nachträglich strukturiert werden, z.B. lithographisch, oder aber auch strukturiert aufgebracht werden, z.B. über eine Maske oder in einem strukturierten Druckprozess.

Nachfolgend werden optional Lotkugeln aus einer definierten Lotlegierung aufgebracht. Dies kann über einen Lotpastendruckprozess mit anschließendem Umschmelzen und Reinigen oder durch Absetzen vorgeformter Lotkugeln und Umschmelzen oder durch eine galvanische Abscheidung von Lotwerkstoff auf die exponierten Lötkontaktflächen geschehen. Optional kann anstatt eines Weichlotes auch ein alternativer Kontaktwerkstoff wie Palladium, Nickel, Gold, Kupfer oder dergleichen aufgebracht werden, vorzugsweise mit Hilfe einer galvanischen Abscheidung.

Weiter oben wurde bereits erwähnt, dass als Substratmaterial für die vorliegende Erfindung ein solches sein kann, das ein- oder sogar beidseitig mit einer Beschichtung, beispielsweise einer Passivierung, bedeckt sein kann.

Da diese Schicht auf der Vorderseite möglicherweise eine Barriere für das fortschreitende Ätzen von der Rückseite her darstellen könnte, wie es z.B. im obenstehenden Fall eines mit SiO₂ bedeckten Siliziumwafers der Fall wäre, wird man in solchen, ggf. aber auch anderes begründeten Fällen die elektrisch leitende Kontaktstelle gegebenenfalls versetzt oben auf, vorzugsweise aber in oder unter der genannten Schicht anordnen. In solchen Fällen lässt sich die Vorderseite des Substrats vorab strukturieren, z.B. durch Abätzen dieser Schicht an den gewünschten Kontaktpunkten und durch Aufbringen des elektrisch leitenden Kontaktmaterials an dieser Stelle.

Die Ausführungsform der vorliegenden Erfindung, die sich insbesondere für die Ankontaktierung vorprozessierter Halbleitersubstrate eignet, sieht daher für derartige Fälle sowie für Fälle, in denen aus anderen Gründen die Kontaktstelle auf der Vorderseite des Substrats nicht direkt von der Rückseite her ankontaktiert werden kann oder soll, die zusätzliche Ausbildung eines Kontaktlochs in Form einer Ausnehmung im Schichtaufbau der Vorderseite vor, derart, dass die Ausnehmung vorzugsweise bis an das Halbleitersubstrat selbst heranreicht. Sofern erforderlich wird diese Ausnehmung sodann mit einer Passivierungsschicht versehen, bevor schließlich eine Metallisierungsschicht darin abgeschieden und strukturiert wird, derart, dass die Metallisierungsschicht den Grund der gebildeten Ausnehmung mit der elektrisch leitenden Kontaktstelle elektrisch leitend verbindet.

Natürlich muss man in solchen Fällen schon im Entwurf eine Stelle ohne aktive elektronische Elemente in der Nähe der vorderseitigen Kontaktstellen vorsehen. Um die Ausnehmung auszubilden, wird die Vorderseite mit einer Maske abgedeckt, z.B. durch Aufbringen und Strukturieren eines Photolacks. Für die Ätzung der Ausnehmung sind je nach Lagenaufbau und eingesetzten Passivierungsmaterialien die verschiedenen in der Halbleiterproduktion bekannten Verfahren einsetzbar, ggf. auch in Kombination. Neben Trockenätzen mit fluorhaltigen Gasmischungen ist eine Nassstrukturierung mit HF-haltigen Säuren möglich. Im Übrigen können natürlich auch diejenigen Verfahren für die Ausbildung der vorderseitigen Ausnehmung eingesetzt werden, die voranstehend für die Rückseitenausnehmung angegeben sind.

Die Form der Ausnehmung kann beliebig gewählt werden. In einer bevorzugten Ausgestaltung der Erfindung weist sie wie die rückseitige Ausnehmung der vorliegenden Erfindung einen Flankenwinkel von etwa 90°-70°, bevorzugt 85°-75° und ganz besonders bevorzugt von etwa 80° auf. Die Ausnehmungen können, müssen aber nicht, gleichmäßig bzw. symmetrisch sein. Die konusähnliche Form der Ausnehmungen kann sich über die gesamte Dicke des Substrates hinweg erstrecken; statt dessen kann man jedoch auch mit einer sog. "Unterätzung" arbeiten, bei der sich der Lochdurchmesser erst kurz hinter der rückseitigen Außenfläche auf seinen maximalen Durchmesser weitet und dann konusförmig verengt. Es ist jedoch gleichermaßen bevorzugt, wenn die Ausnehmung senkrechte Seitenwände besitzt.

Danach wird der Lack entfernt, und je nach Lagenaufbau und Substratmaterial wird gegebenenfalls eine Passivierungsschicht aufgebracht, z.B. vorzugsweise aus SiO₂, wenn das Substrat ein Siliziummaterial ist. Diese kann nachfolgend über eine Lithographie und einen Trockenätzprozess strukturiert werden, und zwar so, dass sowohl die vorderseitige Kontaktstelle als auch ein Kontaktfenster in der Ausnehmung offen sind. Auch dieser Lack wird anschließend wieder entfernt. Auf die Wafer-Vorderseite wird sodann mindestens eine Metallschicht oder ein metallischer Schichtverbund aufgebracht. Als Metallschicht eignet sich beispielsweise eine Aluminiumlegierung wie AlSi₁, AlSi₁Cu_{0,5}. Als Schichtverbund kann ein solcher aus mindestens zwei, ggf. aber auch drei oder sogar mehr Schichten eingesetzt werden, ausgewählt unter Haftvermittler- und/oder Diffusionssperrschichten und einer gut elektrisch leitfähigen Deckschicht. Beispiele für Schichtverbünde sind Ti/TiN/Cu, TiW,/Ni/Au oder Ti/Pt/Au. Diese Schichten können entweder gesputtert (z.B. mit Hilfe von PVD) oder aufgedampft oder über chemische Dampfabscheidung (chemical vapor deposition, CVD) aufgebracht werden. Auch andere Verfahrensvarianten, wie dem vollflächige Metallschicht anschließend strukturiert werden, beispielsweise mit Hilfe eines lithographischen Verfahrens. Hierzu sind je nach Schichtsystem ggf. Trockenätzprozesse einsetzbar; zumeinst werden jedoch Nassätzprozesse, bei edlen Deckschichten auch in unterschiedlichen Ätzlaugen nacheinander, verwendet. Die Lithographiemaske, meist ein Lack, wird anschließend wieder entfernt. Die Strukturierung erfolgt so, dass im Ergebnis eine mehr oder weniger kurze oder direkte elektrische Verbindung zwischen der vorderseitigen Kontaktstelle und der neu in den vorderseitigen Substrataufbau eingebrachten Ausnehmung vorliegt. Die Ausnehmung wird vorzugsweise etwas überlappend zum oberen Rand hin metallisiert; zumindest aber ist eine Leiterbahn vorhanden, die das am Grund der Ausnehmung befindliche Kontaktfenster vollständig überdeckt. Optional kann eine zusätzliche Passivierungsschicht, beispielsweise aus SiO₂ oder SiN, mit einem der beschriebenen Verfahren teilweise oder vollflächig auf der vorderen Oberfläche des Substrataufbaus aufgebracht werden.

Es ist bevorzugt, dass die genannte zusätzliche Ausbildung eines Kontaktlochs in Form einer Ausnehmung im Schichtaufbau der Vorderseite vor dem Ausbilden der rückseitigen Ausnehmung erfolgt. In diesen Fällen wird die rückseitige Ausnehmung anschließend so angebracht, dass sie in Richtung der Vorderseite des Substrats unter der Metallschicht endet, die in die vorderseitige Ausnehmung eingebracht wurde. Dadurch bleibt jederzeit während des Verfahrens das Substrat durchgehend und damit gasundurchlässig, so dass es als Dichtung für die gegenüberliegende Seite bzw. Oberfläche fungieren kann. Liegt unter dieser Metallschicht eine Passivierungsschicht, was wie oben beschrieben optional möglich ist, muss diese entweder das Kontaktfenster von vornherein aussparen oder aber nachträglich von der Rückseite her zusammen mit dem Substrat abgetragen werden.

Alternativ erfolgt das Ausbildung der jeweiligen Ausnehmungen in umgekehrter Reihenfolge. Dann gilt natürlich umgekehrt, dass die Ausnehmung von der Vorderseite her eine möglicherweise vorhandene Passivierungsschicht der rückseitigen Ausnehmung durchstoßen muss.

Durch die voranstehend erläuterte Kontaktführung an die Oberfläche z.B. ursprünglicher Drahtbondpads wird eine signifikante Reduzierung der Betriebsspannung vermieden.

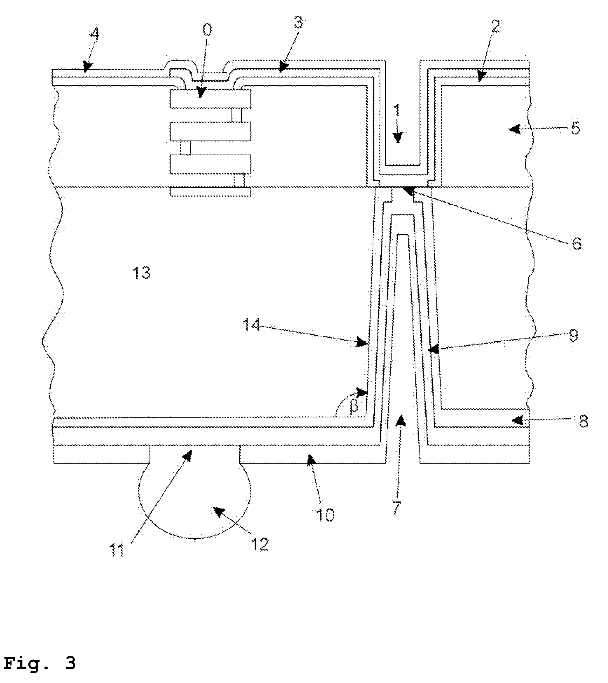

Anhand von Figur 3, die beispielhaft ein Substrat mit frontseitig aufgebrachter IC Prozessierung zeigt, sei nun der mit dem erfindungsgemäßen Verfahren erzielbare Aufbau beschrieben.

Gezeigt ist ein vorprozessiertes Halbleitersubstrat 13 mit originären Kontaktstellen 0, bei denen es sich beispielsweise um Drahtbondflächen handeln kann. Bei 1 ist der vertiefte Frontseitenkontakt gezeigt, der mit Hilfe des voranstehend beschriebenen Verfahrens ausgebildet werden kann. Eine - optional vorhandene - Passivierungslage 2 kleidet die Flanken der Ausnehmung oder des Kontaktlochs 1 aus und deckt überdies den übrigen Schichtaufbau 5 der IC Prozessierung mit Ausnahme der Kontaktstellen 0 ab, ist jedoch im Kontaktbereich der rückseitigen Ankontaktierung nicht vorhanden. Ein möglicherweise vorhandener Haftvermittler oder eine solche Diffusionssperrschicht oberhalb der Passivierungsschicht sind nicht gezeigt, deshalb befindet sich oberhalb der Passivierungslage die Metallisierungsschicht 3, abgedeckt von einer Passivierungsschicht 4. Die Metallisierung 3 verbindet die Kontaktstellen 0 mit dem Kontaktfenster 6 zwischen Front- und Rückseitenkontakt. Die rückseitige Ausnehmung ist leicht konisch ausgebildet; ihre Flanken 14 besitzen einen Flankenwinkel von 180°-β. Sie ist wie die vorderseitige Ausnehmung 1 mit einer Passivierungslage 8 ausgekleidet, die jedoch das Kontaktfenster ausspart. Darauf befinden sich eine Metallisierungsschicht 9 und eine Passivierungsschicht 10. Über die Metallisierung 9 besteht Kontakt zu einer lötbaren Kontaktfläche 11 und einen Lötkontakt 12. Es sollte klar sein, dass auch die Rückseiten-Ausnehmung weitere Schichten aufweisen kann, wie oben für die Vorderseiten-Ausnehmung und des weiteren in der Beschreibung des Verfahrens näher erläutert.

## Patentansprüche

1. Verfahren zum Erzeugen elektrisch leitender Durchführungen durch ein Halb- oder Nichtleitersubstrat, das insbesondere für elektrische Anwendungen geeignet ist, wobei die Vorderseite des Substrats (13) mit einer oder mehreren Schichten (5) sowie mit mindestens einer leitenden Kontaktstruktur (0) innerhalb oder auf dieser/diesen Schicht(en) versehen ist, umfassend die Schritte:
(a) Vorsehen des genannten Halb- oder Nichtleitersubstrats (13),
(b) Ausbilden mindestens einer von der genannten Vorderseite ausgehenden Ausnehmung (1) neben der mindestens einen leitenden Kontaktstruktur (0), die durch die genannten Schicht(en) (5) hindurchreicht,
(c) Aufbringen einer elektrisch leitenden Struktur (3), die zumindest ausgehend von der genannten leitenden Kontaktstruktur (0) bis auf den Grund der genannten Ausnehmung (1) reicht, derart, dass sie eine elektrisch leitende Kontaktstelle (6) bildet;
(d) Ausbilden mindestens einer Ausnehmung (7) im Substrat von dessen Rückseite aus, derart, dass diese Ausnehmung (7) auf der Vorderseite des Substrats unter dem oder einem der Orte endet, an dem sich die oder eine der elektrisch leitenden Kontaktstellen (6) befindet und von dieser vollständig abgedeckt wird,
(e) von der Rückseite des Substrates her erfolgendes Aufbringen einer elektrisch leitenden Struktur (9), die durch die oder mindestens eine der Ausnehmungen (7) hindurch eine leitfähige Verbindung zwischen der jeweiligen Kontaktstelle (6) und der rückseitigen Oberfläche (10, 11, 12) des Substrates herstellt,
wobei die oder jede rückseitige Ausnehmung (7) eine sich in Richtung der Vorderseite des Substrats verkleinernde Querschnittsfläche besitzt und/oder die oder jede vorderseitige Ausnehmung (1) eine sich in Richtung der Kontaktstelle (6) verkleinernde Querschnittsfläche besitzt.

2. Verfahren nach Anspruch 1, **dadurch gekennzeichnet, dass** die leitende Kontaktstruktur (0) in der oder einer der Schichten (5) eingegraben ist.

3. Verfahren nach Anspruch 1 oder 2, **dadurch gekennzeichnet, dass** die rückseitigen und/oder die vorderseitigen Ausnehmung(en) (1, 7) im Substrat im Wesentlichen konusförmig ausgebildet wird/werden und bevorzugt Flankenwinkel von etwa 70-90°, stärker bevorzugt von etwa 75-85° und ganz besonders bevorzugt von etwa 80° erhält/erhalten.

4. Verfahren nach einem der voranstehenden Ansprüche, **dadurch gekennzeichnet, dass** die Ausnehmungen (1, 7) im Substrat durch Ätzen der Rückseite des Substrates gebildet werden, wobei das Ätzen andauert, bis der Ätzprozess die Fläche der leitenden Kontaktstelle(n) (6) zumindest teilweise freigelegt hat, und so rechtzeitig abgebrochen wird, dass die genannte Fläche die durch das Ätzen entstandene Ausnehmungen im Substrat noch dichtend abdeckt.

5. Verfahren nach Anspruch 4, wobei die als für das Ätzen eingesetzte Technik ausgewählt ist unter (a) Plasmaätzen, und zwar bevorzugt mit Hilfe von Schwefelhexafluorid, wenn das Substrat ein Siliziumwafer ist, einem Hochratenätzen oder dem sog. "Deep Reaktive Ion Etching" (DRIE), (b) Nassätzen, ausgewählt unter Ätzen mit einer HF-haltigen Säure oder einer KOH-Ätzung, jeweils unter Verwendung einer geeigneten Maske, und (c) Ätzen mit Hilfe von UV-Laserstrahlung, wobei die Techniken nach (a) und (c) zumindest für die rückseitige Ausnehmung bevorzugt sind.

6. Verfahren nach einem der voranstehenden Ansprüche, worin die elektrisch leitende Struktur (9) auf der Rückseite des Substrats und/oder worin die elektrisch leitenden Struktur (3) auf der Vorderseite des Substrats in Form einer durchgehenden Schicht, die nachträglich strukturiert wird, aufgebracht wird.

7. Verfahren nach einem der Ansprüche 1 bis 5, worin die elektrisch leitende Struktur (9) auf der Rückseite des Substrats und/oder worin die elektrisch leitende Struktur (3) auf der Vorderseite des Substrats als solche, z.B. mit Hilfe lithographischer Verfahren, Druckverfahren oder von Ätzverfahren, aufgebracht wird.

8. Verfahren nach einem der voranstehenden Ansprüche, **dadurch gekennzeichnet dass** vor Schritt (e) eine Passivierungsschicht (8) zumindest auf den Seitenwänden der in Schritt (d) entstandenen Ausnehmungen und auf Wunsch auch auf der Rückseite des Substrats abgeschieden wird und/oder dass vor Schritt (c) eine Passivierungsschicht (2) zumindest auf den Seitenwänden der in Schritt (b) entstandenen Ausnehmung und ggf. auf der Oberfläche der Schicht(en) (14) abgeschieden wird.

9. Verfahren nach Anspruch 8, **dadurch gekennzeichnet, dass** auch die Kontaktstelle (6) auf ihrer Vorder- und/oder Rückseite mit einer Passivierungsschicht (2 und/oder 8) überdeckt wird und diese anschließend durch ein geeignetes Verfahren zumindest teilweise wieder entfernt wird, bevor die leitende Struktur gemäß Schritt (c) und/oder (e) erzeugt wird.

10. Verfahren nach einem der Ansprüche 8 oder 10, **dadurch gekennzeichnet, dass** die Passivierungsschicht (2, 8) durch Oxidation und/oder Nitrierung des Substratmaterials durch Sputtertechnik oder plasmaunterstützte CVD aufgebracht wird, insbesondere für den Fall, dass das Substrat ein Siliziumwafer ist, und/oder durch Aufbringen eines organischen oder anorganisch-organischen Polymermaterials erzeugt wird.

11. Verfahren nach einem der Ansprüche 8 bis 10, **dadurch gekennzeichnet, dass** die Passivierungsschicht (2, 8) 0,4 bis 2 µm dick ist.

12. Verfahren nach einem der voranstehenden Ansprüche, **dadurch gekennzeichnet, dass** die Rückseite des Substrats nach Schritt (e) und/oder die Oberseite der Schicht(en) (5) mit einer strukturierten Passivierungsschicht (4, 10) abgedeckt wird, wobei diejenigen Orte der leitenden Struktur, die nachfolgend als elektrische Kontaktpunkte oder Sägestraßen dienen sollen, frei von der Passivierungsschicht bleiben.

13. Verfahren nach Anspruch 12, **dadurch gekennzeichnet, dass** die Passivierungsschicht (4, 10) aus einem organischen Polymeren, vorzugsweise Benzocyclobuten oder Polyimid, besteht.

14. Verfahren nach Anspruch 12 oder 13, **dadurch gekennzeichnet, dass** die Passivierungsschicht (4, 10) als durchgehende Schicht aufgebracht und anschließend, vorzugsweise lithographisch, strukturiert wird.

15. Verfahren nach Anspruch 12 oder 13, **dadurch gekennzeichnet, dass** die Passivierungsschicht (4, 10) in strukturierter Form, vorzugsweise durch ein Druckverfahren, aufgebracht wird.

16. Verfahren nach einem der voranstehenden Ansprüche, **dadurch gekennzeichnet, dass** auf denjenigen Orten der leitenden Struktur, die als rückseitige elektrische Kontaktpunkte dienen sollen, ein Kontaktwerkstoff und/oder ein Lotmaterial aufgebracht wird.

17. Verfahren nach Anspruch 16, dass der Kontaktwerkstoff aus einem leitenden Metall, vorzugsweise Palladium, Nickel, Kupfer oder Gold besteht und besonders bevorzugt durch galvanische Abscheidung aufgebracht wird.

18. Verfahren nach Anspruch 17, **dadurch gekennzeichnet, dass** Lotkugeln aus einem Weichlot aufgebracht werden, vorzugsweise über einen Lotpastendruckprozess mit anschließendem Umschmelzen und Reinigen oder durch Absetzen vorgeformter Lotkugeln und Umschmelzen.

19. Mit mindestens einer elektrischen Durchführung versehenes Nicht- oder Halbleitersubstrat, wobei die Durchführung dadurch realisiert ist, dass das Substrat (13) auf seiner Vorderseite an mindestens einem Ort eine elektrisch leitende Kontaktstelle (6) aufweist, die mit einer elektrisch leitenden Struktur (9) verbunden ist, welche sich durch eine Ausnehmung (7) im Substrat und bis auf dessen rückseitige Fläche erstreckt, wobei die Ausnehmung zur Vorderseite des Substrats hin vollständig von der genannten elektrisch leitenden Struktur abgedeckt ist, und dass die Vorderseite des Substrats (13) mit einer oder mehreren Schichten (5) sowie mit mindestens einer leitenden Kontaktstruktur (0) innerhalb oder auf dieser/diesen Schicht(en) versehen ist und die Kontaktstelle (6) sich am Grund einer Vertiefung (1) neben der mindestens einen leitenden Kontaktstruktur (0) befindet, die ausgehend von der Oberfläche durch die eine oder mehreren Schichten (5) hindurchreicht, derart, dass die elektrisch leitende Kontaktstruktur (0) und die Vertiefung voneinander beabstandet und durch eine elektrisch leitende Struktur (3) miteinander verbunden sind, worin die oder jede rückseitige Ausnehmung (7) eine sich in Richtung der Vorderseite des Substrats verkleinernde Querschnittsfläche besitzt und/oder die oder jede vorderseitige Ausnehmung (1) eine sich in Richtung der Kontaktstelle (6) verkleinernde Querschnittsfläche besitzt.

20. Substrat nach Anspruch 19, bei dem es sich um einen Siliziumwafer handelt.

21. Substrat nach einem der Ansprüche 19 oder 20, **dadurch gekennzeichnet, dass** mindestens die Flanken mindestens einer der Ausnehmungen (1, 7) durch eine Passivierungsschicht (2, 8) abgedeckt sind, die die jeweilige elektrisch leitende Struktur (3, 9) vom Substrat isoliert.

22. Substrat nach einem der Ansprüche19 bis 21, **dadurch gekennzeichnet, dass** die Rückseite des Substrats mit einer Passivierungsschicht (10) und/oder die Oberfläche der Schicht(en) (5) mit einer Passivierungsschicht (4) abgedeckt ist/sind, die nur diejenigen Orte der elektrisch leitenden Struktur offen lässt, die als elektrische Kontaktpunkte (11, 12) vorgesehen sind.

23. Substrat nach einem der Ansprüche 19 bis 22, **dadurch gekennzeichnet, dass** auf denjenigen Orten der elektrisch leitenden Struktur, die als elektrische Kontaktpunkte (11, 12) vorgesehen sind, ein Kontaktmaterial, vorzugsweise aus Palladium, Nickel, Gold oder Kupfer, und/oder ein Lotmaterial, vorzugsweise in Form von umgeschmolzenen Lotkugeln, vorhanden ist.

24. Substrat nach Anspruch 23, **dadurch gekennzeichnet, dass** sich mindestens einer der elektrischen Kontaktpunkte (11, 12) zumindest teilweise über der Ausnehmung befindet, durch die er mit der ersten elektrisch leitenden Struktur verbunden ist.

25. Substrat nach Anspruch 23, **dadurch gekennzeichnet, dass** sich mindestens einer der elektrischen Kontaktpunkte (11, 12) beabstandet von der Ausnehmung befindet, durch die er mit der ersten elektrisch leitenden Struktur verbunden ist.

## Claims

1. Method for producing electrically conductive bushings through a semiconductive or non-conductive substrate, which is particularly suitable for electric applications, wherein the front side of the substrate (13) is provided with one or more layers (5)as well as with at least one electrically conducting contact structure (0) within or on said layer(s), comprising the steps:
(a) providing said semiconductive or non-conductive substrate (13)
(b) forming at least one recess (1) starting from the said front side that extends through the said layer(s) (5), beside the said at least one conducting contact structure (0),
(c) applying an electrically conductive structure (3) which extends, at least starting from the said conductive contact structure (0), up to the base of the at least one recess (1), such that it forms an electrically conductive contact point (6),
(d) forming, from its rear side, at least one recess (7) in the substrate, such that this recess (7) ends on the front side of the substrate below that location or below one of the locations where the electrically conductive contact point (6) or one of the said electrically conductive contact points (6) is situated, and is completely covered by the latter,
(e) applying from the rear side of the substrate an electrically conductive structure (9), which establishes a conductive connection between the respective contact point (6) and the rear-side surface (10, 11, 12) of the substrate through the said recess or at least one of the recesses,
wherein the or each rear-side recess (7) has a cross-sectional area which becomes smaller in the direction of the front side of the substrate and/or wherein the or each front-side recess (1) has a cross-sectional area which becomes smaller in the direction of the said contact point.

2. Method in accordance with claim 1, **characterized in that** the said conductive contact structure (0) is buried in the said or one of the said layers (5).

3. Method in accordance with claim 1 or 2, **characterized in that** the said rear-side and/or the front-side recess(es) (1, 7) in the substrate has/have an essentially cone-shaped design and preferably forms/form side angles of about 70-90°, more preferably of about 75-85° and especially preferably of about 80°.

4. Method in accordance with any of the preceding claims, **characterized in that** the recesses (1, 7) in the substrate are formed by etching of the rear side of the substrate, whereby the etching lasts until the etching process has at least partly exposed the area of the said conductive contact point(s) (6), and is ended in a timely manner, such that the said area still covers the recesses in the substrate that have been formed by the etching, in a sealing manner.

5. Method in accordance with claim 4, wherein the technique used for the etching is selected from among (a) plasma etching, the same preferably using sulfur hexafluoride, if the substrate is a silicon wafer, a high-rate etching, or the so-called "Deep Reactive Ion Etching" (DRIE), (b) wet etching, selected from among etching with an HF-containing acid or KOH etching, in each case using a suitable mask, and (c) etching by means of UV laser irradiation, whereby the techniques according to (a) and (c) are preferred at least for the rear-side recess.

6. Method in accordance with one of the preceding claims, wherein the electrically conductive structure (9) on the rear side of the substrate and/or wherein the said electrically conductive structure (3) on the front side of the substrate is applied in the form of a continuous layer, which is subsequently structured.

7. Method in accordance with any of claims 1 through 5, wherein the said electrically conductive structure (9) on the rear side of the substrate and/or wherein the said electrically conductive structure (3) on the front side of the substrate is applied as such, e.g., by means of lithographic methods, printing methods or etching methods.

8. Method in accordance with any of the preceding claims, **characterized in that** prior to step (e), a passivation layer (8) is deposited at least on the side walls of the recesses formed in step (d) and, if desired, also on the rear side of the substrate, and/or that prior to step (c), a passivation layer (2) is deposited at least on the side walls of the recess formed in step (b) and optionally on the surface of the layer(s) (14).

9. Method in accordance with claim 8, **characterized in that** the contact point (6) on its front side and/or rear side is also covered with a passivation layer (2 and/or 8) and this is subsequently at least partly removed again by means of a suitable method, before the conductive structure is produced according to step (c) and/or (e).

10. Method in accordance with any of claims 8 or 9, **characterized in that** said passivation layer (2, 8) is applied by oxidation and/or nitration of the substrate material by means of sputter technology or plasma-supported CVD, particularly if the substrate is a silicon wafer, and/or is produced by applying an organic or inorganic-organic polymer material.

11. Method in accordance with one of the claims 8 through 10, **characterized in that** the said passivation layer (2, 8) has a thickness of 0.4 to 2 mm.

12. Method in accordance with any of the preceding claims, **characterized in that** the rear side of the substrate after step (e) and/or the upper side of the layer(s) (5) is/are covered with a structured passivation layer (4, 10), whereby those locations of the conductive structure, which are to be subsequently used as electrical contact points or saw streets, remain uncovered by the passivation layer.

13. Method in accordance with claim 12, **characterized in that** the passivation layer (4, 10) consists of an organic polymer, and preferably benzocyclobutene or polyimide.

14. Method in accordance with claim 12 or 13, **characterized in that** the passivation layer (4, 10) is applied as a continuous layer and is subsequently structured, preferably by means of lithography.

15. Method in accordance with claim 12 or 13, **characterized in that** the said passivation layer (4, 10) is applied in structured form, preferably by means of a printing method.

16. Method in accordance with any of the preceding claims, **characterized in that** a contact material and/or a soldering material is applied to those locations of the conductive structure that are to be used as rear-side electrical contact points.

17. Method in accordance with claim 16, **characterized in that** the contact material consists of a conductive metal, preferably palladium, nickel, copper or gold, and is applied especially preferably by means of galvanic deposition.

18. Method in accordance with claim 17, **characterized in that** solder globules consisting of a soft solder are applied, preferably via a solder paste printing process with subsequent remelting and cleaning or by depositing preformed solder globules and remelting.

19. Non-conductive or semiconductive substrate provided with at least one electrical bushing, wherein the bushing has been realized in that the substrate (13) has an electrically conductive point (6) on its front side at at least one location, the conductive point (6) being connected to an electrically conductive structure (9) which extends through a recess (7) in the substrate and down to its rear-side area, wherein the recess towards the front side of the substrate is completely covered by the said electrically conductive structure, and wherein the front side of the substrate (13) is provided with one or more layer(s) (5) as well as with at least one conductive contact structure (0) within or on this/these layer(s) and the said contact point (6) is situated at the base of a recess (1) beside the at least one conductive contact structure (0) which, starting from the surface, extends through the one or more layers (5), whereby the electrically conductive contact structure (0) and the recess are at a distance from one another and are connected to one another by means of an electrically conductive layer (3), wherein the or each rear-side recess (7) has a cross-sectional area which becomes smaller in the direction of the front side of the substrate and/or wherein the or each front-side recess (1) has a cross-sectional area which becomes smaller in the direction of the said contact point (6).

20. Substrate according to claim 19 which is a silicon wafer.

21. Substrate in accordance with any of claims 19 or 20, **characterized in that** at least the slopes of at least one of the recesses (1, 7) are covered by a passivation layer (2,8) which insulates the respective electrically conductive structure (3, 9) from the substrate.

22. Substrate in accordance with any of claims 19 to 21, **characterized in that** the rear side of the substrate is covered with a passivation layer (10) and/or the surface of the layer(s) (5) is covered with a passivation layer (4), which leaves open only those locations of the electrically conductive structure that are intended to be electrical contact points (11, 12).

23. Substrate in accordance with any of claims 19 through 22, **characterized in that** a contact material, preferably made of palladium, nickel, gold or copper, and/or a soldering material, preferably in the form of remelted solder globules, is present on those locations of the electrically conductive structure that are intended to be electrical contact points (11, 12).

24. Substrate in accordance with claim 23, **characterized in that** at least one of the said electrical contact points (11, 12) is situated at least partly above that recess via which it is connected to the first electrically conductive structure.

25. Substrate in accordance with claim 23, **characterized in that** at least one of the said electrical contact points (11, 12) is situated at a distance from that recess via which it is connected to the first electrically conductive structure.

## Revendications

1. Procédé de fabrication de trous traversants conducteurs de l'électricité à travers un substrat semi-conducteur ou non conducteur, qui est particulièrement approprié pour des applications électriques, dans lequel la face avant du substrat (13) est munie d'une ou de plusieurs couche(s) (5) ainsi que d'au moins une structure de contact conductrice (0) à l'intérieur de ou sur cette/ces couche(s), comprenant les étapes suivantes:
(a) procurer ledit substrat semi-conducteur ou non conducteur (13),
(b) former au moins un évidement (1) partant de ladite face avant à côté de ladite au moins une structure de contact conductrice (0), qui passe à travers ladite/lesdites couche (s) (5),
(c) déposer une structure électriquement conductrice (3), qui partant au moins de ladite structure de contact conductrice (0) arrive jusque sur le fond dudit évidement (1), de telle manière qu'elle forme un point de contact électriquement conducteur (6);
(d) former au moins un évidement (7) dans le substrat à partir de sa face arrière, de telle manière que cet évidement (7) se termine sur la face avant du substrat sous la ou une des zone(s) sur laquelle/lesquelles se trouve le ou un des point(s) de contact électriquement conducteur(s) (6) et se trouve complètement recouvert par celui-ci,
(e) poser sur la face arrière du substrat une structure électriquement conductrice (9), qui établit à travers le ou au moins un des évidement(s) (7) une connexion conductrice entre le point de contact respectif (6) et la surface (10, 11, 12) de la face arrière du substrat,
dans lequel le ou chaque évidement de face arrière (7) possède une aire de section transversale décroissante en direction de la face avant du substrat et/ou le ou chaque évidement de face avant (1) possède une aire de section transversale décroissante en direction du point de contact (6).

2. Procédé selon la revendication 1, **caractérisé en ce que** la structure de contact conductrice (0) est enterrée dans la ou une des couches (5).

3. Procédé selon la revendication 1 ou 2, **caractérisé en ce que** le/les évidement(s) de face arrière et/ou de face avant (1, 7) dans le substrat est/sont réalisé(s) essentiellement en forme de cône et présente(nt) de préférence des angles de flanc d'environ 70-90°, de préférence encore d'environ 75-85° et en particulier de préférence d'environ 80°.

4. Procédé selon l'une quelconque des revendications précédentes, **caractérisé en ce que** les évidements (1, 7) dans le substrat sont formés par gravure de la face arrière du substrat, dans lequel la gravure dure jusqu'à ce que le processus de gravure ait dégagé au moins en partie la face du/des point(s) de contact conducteur(s) (6), et elle est interrompue à temps afin que ladite face recouvre encore de façon étanche les évidements dans le substrat créés par la gravure.

5. Procédé selon la revendication 4, dans lequel la technique utilisée pour la gravure est choisie parmi
(a) la gravure au plasma, notamment de préférence à l'aide d'hexafluorure de soufre, lorsque le substrat est une galette de silicium, une gravure à grande vitesse ou la gravure ionique réactive profonde (DRIE),
(b) la gravure humide, choisie parmi la gravure avec un acide contenant du HF ou une gravure au KOH, chaque fois en utilisant un masque approprié, et (c) la gravure à l'aide d'un rayonnement laser UV, les techniques selon (a) et (c) étant préférées au moins pour l'évidement de face arrière.

6. Procédé selon l'une quelconque des revendications précédentes, dans lequel on dépose la structure électriquement conductrice (9) sur la face arrière du substrat et/ou dans lequel on dépose la structure électriquement conductrice (3) sur la face avant du substrat sous la forme d'une couche continue, qui est structurée postérieurement.

7. Procédé selon l'une quelconque des revendications 1 à 5, dans lequel on dépose la structure électriquement conductrice (9) sur la face arrière du substrat et/ou dans lequel on applique la structure électriquement conductrice (3) sur la face avant du substrat comme telle, par exemple à l'aide d'un procédé lithographique, d'un procédé d'impression ou d'un procédé de gravure.

8. Procédé selon l'une quelconque des revendications précédentes, **caractérisé en ce qu'**avant l'étape (e) on dépose une couche de passivation (8) au moins sur les parois latérales des évidements formés à l'étape (d) et si on le souhaite aussi sur la face arrière du substrat et/ou **en ce qu'**avant l'étape (c) on dépose une couche de passivation (2) au moins sur les parois latérales de l'évidement formé à l'étape (b) et éventuellement sur la surface de la/des couche(s) (14).

9. Procédé selon la revendication 8, **caractérisé en ce que** l'on recouvre aussi le point de contact (6) sur sa face avant et/ou arrière avec une couche de passivation (2 et/ou 8) et on enlève ensuite celle-ci au moins en partie par un procédé approprié, avant de produire la structure conductrice selon l'étape (c) et/ou (e).

10. Procédé selon une des revendications 8 ou 10, **caractérisé en ce que** l'on dépose la couche de passivation (2, 8) par oxydation et/ou nitruration du matériau du substrat par une technique de pulvérisation cathodique ou par CVD assisté par plasma, en particulier pour le cas où le substrat est une galette de silicium, et/ou on la produit en déposant un matériau polymère organique ou inorganique-organique.

11. Procédé selon l'une quelconque des revendications 8 à 10, **caractérisé en ce que** la couche de passivation (2, 8) a une épaisseur de 0,4 à 2 µm.

12. Procédé selon l'une quelconque des revendications précédentes, **caractérisé en ce que** l'on recouvre la face arrière du substrat après l'étape (e) et/ou la face supérieure de la/des couche(s) (5) avec une couche de passivation structurée (4, 10), dans lequel les zones de la structure conductrice, qui doivent servir ensuite de points de contact électriques ou de lignes de sciage, restent libres de la couche de passivation.

13. Procédé selon la revendication 12, **caractérisé en ce que** la couche de passivation (4, 10) se compose d'un polymère organique, de préférence de benzocyclobutène ou de polyimide.

14. Procédé selon la revendication 12 ou 13, **caractérisé en ce que** l'on dépose la couche de passivation (4, 10) sous forme de couche continue et on la structure ensuite, de préférence par lithographie.

15. Procédé selon la revendication 12 ou 13, **caractérisé en ce que** l'on dépose la couche de passivation (4, 10) sous forme structurée, de préférence par un procédé d'impression.

16. Procédé selon l'une quelconque des revendications précédentes, **caractérisé en ce que** l'on dépose une matière de contact et/ou un matériau de brasage sur les zones de la structure conductrice, qui doivent servir de points de contact électriques sur la face arrière.

17. Procédé selon la revendication 16, **caractérisé en ce que** la matière de contact se compose d'un métal conducteur, de préférence de palladium, de nickel, de cuivre ou d'or et on la dépose en particulier de préférence par dépôt galvanique.

18. Procédé selon la revendication 17, **caractérisé en ce que** l'on dépose des billes de brasage en une brasure tendre, de préférence par un processus d'impression avec pâte à braser avec fusion ultérieure et nettoyage ou par dépôt de billes de brasure préformées et fusion.

19. Substrat non conducteur ou semi-conducteur doté d'au moins un trou traversant électrique, dans lequel le trou traversant est réalisé en ce que le substrat (13) présente sur sa face avant, en au moins un endroit, un point de contact électriquement conducteur (6), qui est relié à une structure électriquement conductrice (9), qui s'étend à travers un évidement (7) dans le substrat et jusqu'à la face arrière de celui-ci, dans lequel l'évidement en direction de la face avant du substrat est entièrement recouvert par ladite structure électriquement conductrice, et en ce que la face avant du substrat (13) est munie d'une ou de plusieurs couche(s) (5) ainsi que d'au moins une structure de contact conductrice (0) à l'intérieur de ou sur cette/ces couche(s) et le point de contact (6) se trouve au fond d'un creux (1) à côté de ladite au moins une structure électriquement conductrice (0), qui partant de la surface traverse ladite/lesdites une ou plusieurs couche(s) (5), de telle manière que la structure de contact électriquement conductrice (0) et le creux soient espacés l'un de l'autre et soient reliés l'un à l'autre par une structure électriquement conductrice (3), dans lequel le ou chaque évidement de face arrière (7) possède une aire de section transversale décroissante en direction de la face avant du substrat et/ou le ou chaque évidement de face avant (1) possède une aire de section transversale décroissante en direction du point de contact (6).

20. Substrat selon la revendication 19, dans lequel il est constitué par une galette de silicium.

21. Substrat selon une des revendications 19 ou 20, **caractérisé en ce qu'**au moins les flancs d'au moins un des évidements (1, 7) sont recouverts par une couche de passivation (2, 8), qui isole la structure électrique conductrice respective (3, 9) du substrat.

22. Substrat selon l'une quelconque des revendications 19 à 21, **caractérisé en ce que** la face arrière du substrat est recouverte avec une couche de passivation (10) et/ou la surface de la/des couche(s) (5), est recouverte avec une couche de passivation (4), qui ne laisse ouvertes que les zones de la structure électriquement conductrice, qui sont prévues comme points de contact électriques (11, 12).

23. Substrat selon l'une quelconque des revendications 19 à 22, **caractérisé en ce qu'**il se trouve, sur les zones de la structure électriquement conductrice qui sont prévues comme points de contact électriques (11, 12), un matériau de contact, de préférence en palladium, nickel, or ou cuivre, et/ou un matériau de brasage, de préférence sous forme de billes de brasure fondues.

24. Substrat selon la revendication 23, **caractérisé en ce qu'**au moins un des points de contact électriques (11, 12) se trouve au moins en partie au-dessus de l'évidement, à travers lequel il est relié à la première structure électriquement conductrice.

25. Substrat selon la revendication 23, **caractérisé en ce qu'**au moins un des points de contact électriques (11, 12) se trouve à distance de l'évidement, à travers lequel il est relié à la première structure électriquement conductrice.
